# EUROPÄISCHE PATENTSCHRIFT

(11) **EP 1 881 753 B1**
(45) Veröffentlichungstag und Bekanntmachung des Hinweises auf die Patenterteilung: **14.01.2015**
(21) Anmeldenummer: 07109234.0
(22) Anmeldetag: 30.05.2007
(51) Int. Cl.: H05K 13/00, H05K 13/04, H05K 13/08, G01B 11/27

(54) **Bestimmung der Orientierung einer Kamera relativ zu einer Referenzebene**
Determination of the orientation of a camera relative to a reference plane
Détermination de l'orientation d'une caméra par rapport à une surface de référence

(30) Priorität: 20.07.2006 DE 102006033685
(43) Veröffentlichungstag der Anmeldung: 23.01.2008
(73) Patentinhaber: ASM Assembly Systems GmbH & Co. KG, 81379 München (DE)
(72) Erfinder: Besch, Karl-Heinz, 82140, Olching (DE); Neumaier, Klaus, 81369, München (DE); Treiber, Marco, 80997, München (DE)
(74) Vertreter: Dilg, Haeusler, Schindelmann Patentanwaltsgesellschaft mbH

(56) Entgegenhaltungen:
- DE-A1-102004 028 191
- DE-C1- 19 839 999
- US-A- 6 050 151

## Beschreibung

Die vorliegende Erfindung betrifft Verfahren zum Bestimmen der Orientierung einer Kamera relativ zu einer Referenzebene.

Die vorliegende Erfindung betrifft ferner einen Bestückautomaten, welcher zur Durchführung des erfindungsgemäßen Verfahrens zum Bestimmen der Orientierung einer Kamera relativ zu einer Referenzebene eingerichtet ist.

Aufgrund der zunehmenden Miniaturisierung von elektronischen Baugruppen werden an die Bestückgenauigkeit von modernen Bestückautomaten hohe Anforderungen gestellt. Mittels Bestückautomaten werden elektronische Bauelemente auf einen elektronischen Bauelementeträger, beispielsweise eine Leiterplatte oder einen sonstigen Schaltungsträger platziert. Da die Bestückgenauigkeit im Verlauf des Betriebes eines Bestückautomaten insbesondere durch thermische Verzüge stets Schwankungen unterworfen ist, ist es erforderlich, die Bestückgenauigkeit von Zeit zu Zeit zu überprüfen und den Bestückautomaten gegebenenfalls neu zu kalibrieren.

Aus der DE 198 39 999 C1 ist ein Verfahren zum Kalibrieren eines Verfahrwegs und/oder einer Winkellage einer Haltevorrichtung in einer Einrichtung zur Herstellung von elektrischen Baugruppen bekannt. Dabei wird ein Sensorkorrekturfaktor ermittelt, indem die Lage zweier Korrekturmarken, die in einem vorgegebenen Nennabstand und einer vorgegebenen Lage zueinander auf einem Kalibriersubstrat angebracht sind, mit einer Leiterplattenkamera vermessen wird. Das Ergebnis der Messung wird mit dem Nennabstand verglichen.

Aus der DE 10 2004 028 191 A ist eine Verfahren und eine Vorrichtung zur quantitativen Erfassung der Lage der optischen Achse eines optoelektronischen Sensorsystems bekannt. Das optoelektronische Sensorsystem umfasst eine Quelle paralleler Strahlung und eine Einrichtung zur definierten Verstellung des optoelektronischen Sensorsystems. Zwischen der Quelle paralleler Strahlung und dem optoelektronischen Sensorsystem ist ein beugendes Medium angeordnet, dessen Flächennormale parallel zur Strahlung der Quelle ist. Das beugende Medium erzeugt in der Bildebene des optoelektronischen Sensorsystems ein symmetrisches Beugungsbild, welches von translatorischen und rotatorischen Verschiebungen abhängig ist. Das resultierende Beugungsbild ist hinsichtlich der Symmetrie mit einem Eichbeugungsbild vergleichbar. Mittels der o.g. Einrichtung ist das optoelektronische Sensorsystem derart nachführbar, dass das resultierende Beugungsbild hinsichtlich der Symmetrie mit dem Eichbeugungsbild innerhalb vorgebbarer Grenzen übereinstimmt.

Aus der US 6,050,151 ist ein Verfahren zum Kalibrieren eines Bestückungsautomaten bekannt. Das Verfahren umfasst (a) ein Aufnehmen eines kalibrierten Bauelements, welches eine erste Kalibrierungsmarke aufweist, (b) ein Platzieren des kalibrierten Bauelements auf einer kalibrierten Platte, welche eine zweite Kalibrierungsmarke aufweist und welche sich auf einem Tisch des Bestückungsautomaten befindet, und (c) ein Vergleichen der relativen Ausrichtung der ersten Kalibrierungsmarke und der zweiten Kalibrierungsmarke.

Aus der US 5,249,349 A ist ein Verfahren bekannt, bei dem ein bestücktes Bauelement unmittelbar nach dem Aufsetzen auf einen Bauelementeträger von zwei seitlich angeordneten Kameras erfasst wird, welche die Bestückposition unter einem schrägen Winkel erfassen. Somit kann unmittelbar nach dem Aufsetzen des Bauelements die effektive Bestückposition vermessen werden. Dieses Verfahren hat jedoch den Nachteil, dass die Bestückgenauigkeit erst nach dem eigentlichen Bestückvorgang erfasst wird, so dass bei außerhalb einer bestimmten Toleranz liegenden Positionsversätzen die Bauelemente wieder entfernt und neu aufgesetzt werden müssen.

Aus der EP 0 968 637 B1 ist ein Verfahren zum Kalibrieren einer Bestückvorrichtung zur Herstellung von elektronischen Baugruppen bekannt, bei dem eine Test-Leiterplatte mittels so genannten Kalibrierungsbauelementen bestückt wird. Die Kalibrierungsbauelemente sind typischerweise aus Glas hergestellte und mit einer Struktur versehene scheibenartige Nachbildungen von Bauelementen, welche eine Dicke von ca. 1 mm aufweisen. Die genaue Lage der bestückten Kalibrierungsbauelemente relativ zu Referenzmarken auf der Test-Leiterplatte wird von einem optischen Sensor erfasst und daraus die Abweichungen der realen Bestückpositionen von ihren jeweiligen SollPositionen bestimmt. Auf diese Weise kann die Bestückgenauigkeit und der Positionsversatz eines Bestückautomaten für jede Position auf der Test-Leiterplatte ermittelt werden. Das beschriebene Kalibrierverfahren hat jedoch den Nachteil, dass zur Vermeidung eines Parallaxe-Effekts infolge einer nicht unter 90° zur Test-Leiterplatte orientierten Kamera sehr dünne Kalibrierungsbauelemente erforderlich sind. Dieses Kalibrierverfahren ist somit bei Verwendung von Kalibrierungsbauelementen, die eine größere Höhenausdehnung aufweisen, kaum zu gebrauchen.

Der Erfindung liegt die Aufgabe zugrunde, die Orientierung einer Kamera relativ zu einer Referenzebene und damit eine gegebenenfalls vorhandene Verkippung der Kamera relativ zu der Referenzebene auf einfache Weise exakt zu bestimmen.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Gemäß dem unabhängigen Anspruch 1 wird ein Verfahren zum Bestimmen der Orientierung einer Kamera relativ zu einer Referenzebene, insbesondere einer Kamera zur Vermessung von Kalibrierungsbauelementen in einem Bestückautomaten, angegeben. Das angegebene Verfahren weist folgende Schritte auf: (a) Erfassen einer optischen Verschiebung einer in der Referenzebene ausgebildeten Referenzstruktur, wobei die optische Verschiebung durch ein refraktives optisches Element verursacht wird, welches zwischen der Kamera und der Referenzstruktur angeordnet ist, und (b) Ermitteln der Orientierung der Kamera relativ zu der Referenzebene basierend auf der erfassten optischen Verschiebung mittels einer der Kamera nachgeschalteten Auswerteeinheit. Erfindungsgemäß weist das Erfassen der optischen Verschiebung der Referenzstruktur folgende Schritte auf: (a1) Aufnehmen eines ersten Kamerabildes von zumindest einem Teil der Referenzstruktur, (a2) Einbringen des refraktiven optischen Elements zwischen der Referenzstruktur und der Kamera, und (a3) Aufnehmen eines zweiten Kamerabildes von zumindest dem Teil der Referenzstruktur.

Der Erfindung liegt die Erkenntnis zugrunde, dass eine derartige durch ein refraktives optisches Element verursachte Verschiebung der Referenzstruktur insbesondere von dem Winkel abhängt, unter dem die Referenzstruktur durch das refraktive Element hindurch von der Kamera erfasst wird. Dabei bewirkt eine durch das Brechungsgesetz von Snellius beschriebene Lichtbrechung von schräg auf das optisch refraktive Element einfallenden Lichtstrahlen eine optische Verschiebung der Referenzstruktur parallel zu der Referenzebene. Diese optische Verschiebung ist bei einer genauen Kenntnis sowohl der geometrischen Abmessungen als auch der refraktiven Eigenschaften des optischen Elements ein unmittelbares Maß für den exakten Beobachtungswinkel bzw. für die exakte Orientierung der Kamera relativ zu der Referenzebene. Die refraktiven Eigenschaften des optischen Elements werden dabei insbesondere durch den Brechungsindex des Materials bestimmt, aus welchem das optisch refraktive Element hergestellt ist.

Bei einer durch das erfindungsgemäße Verfahren gewonnenen genauen Kenntnis der Orientierung der Kamera kann somit das in der EP 0 968 637 B1 beschriebenen Kalibrierverfahren so durchgeführt werden, dass die aufgrund des so genannten Parallaxe-Effekts verursachte optische Verschiebung der Referenzmarken berechnet und bei der Bestimmung der Position der Kalibrierbauelemente auf der Test-Leiterplatte berücksichtigt wird. Auf diese Weise kann die Messgenauigkeit des genannten Kalibrierverfahrens auf einfache Weise erheblich erhöht werden.

Bei der Vermessung von bestückten Bauelementen bzw. von zum Zwecke der Kalibrierung eines Bestückautomaten bestückten Kalibrierungsbauelemente ist die Kamera in ihrer Solllage relativ zu der Referenzebene derart angeordnet, dass die optische Achse der Kamera senkrecht zu der Referenzebene orientiert ist. Im Folgenden ist unter dem Begriff Verkippung derjenige Winkel zu verstehen, den die optische Achse der Kamera mit der Flächennormalen der Referenzebene einschließt.

Die erfindungsgemäße sequentielle Bestimmung der durch das optische Element bewirkten Verschiebung der Referenzstruktur mittels zumindest zweier nacheinander aufgenommener Kamerabilder hat den Vorteil, dass an die Genauigkeit der Positionierung des optischen Elements keine besonderen Anforderungen gestellt werden müssen. Das optische Element kann demzufolge nach der Aufnahme des ersten Kamerabildes an einem beliebigen Ort zwischen der Referenzstruktur und der Kamera eingebracht werden.

Gemäß Anspruch 2 ist das refraktive optische Element eine planparallele optisch transparente Platte. Dies hat den Vorteil, dass das beschriebene Verfahren auf einfache Weise mittels einer gewöhnlichen Glasplatte durchgeführt werden kann. Bei einer nicht vorhandenen Verkippung der Kamera, das heißt die optische Achse der Kamera steht exakt senkrecht zu der Referenzebene, wird sich somit keine Verschiebung der Referenzstruktur ergeben bzw. die Verschiebung hat den Wert null. Je größer der Verkippungswinkel der Kamera ist, desto größer wird die durch das refraktive optische Element verursachte Verschiebung der Referenzstruktur sein.

Gemäß dem unabhängigen Anspruch 3 wird ein Verfahren zum Bestimmen der Orientierung einer Kamera relativ zu einer Referenzebene, insbesondere einer Kamera zur Vermessung von Kalibrierungsbauelementen in einem Bestückautomaten, angegeben. Das angegebene Verfahren weist folgende Schritte auf: (a) Erfassen einer optischen Verschiebung einer in der Referenzebene befindlichen Referenzstruktur, wobei die optische Verschiebung durch ein refraktives optisches Element verursacht wird, welches zwischen der Kamera und der Referenzstruktur angeordnet ist, und (b) Ermitteln der Orientierung der Kamera relativ zu der Referenzebene basierend auf der erfassten optischen Verschiebung mittels einer der Kamera nachgeschalteten Auswerteeinheit. Dabei umfasst das Erfassen der optischen Verschiebung der Referenzstruktur eine Auswertung eines Kamerabildes, welches Kamerabild sowohl einen ersten Teilbereich der Referenzstruktur als auch einen zweiten Teilbereich der Referenzstruktur zeigt. Das refraktive optische Element deckt lediglich den zweiten Teilbereich ab oder das refraktive optische Element weist eine gestufte Form auf, die zumindest einen ersten Abschnitt mit einer ersten optischen Dicke und einen zweiten Abschnitt mit einer im Vergleich zu der ersten optischen Dicke unterschiedlichen zweiten optischen Dicke aufweist. Erfindungsgemäß wird das refraktive optische Element derart positioniert, dass der erste Abschnitt den ersten Teilbereich bedeckt und der zweite Abschnitt den zweiten Teilbereich bedeckt.

Bevorzugt ist der erste Teilbereich unmittelbar neben dem zweiten Teilbereich angeordnet, so dass die Bilder nahe beieinander liegender Strukturen miteinander verglichen werden können. Dies hat zur Folge, dass stets vorhandene optische Abbildungsfehler einer verwendeten Kamera lediglich einen zu vernachlässigenden Einfluss auf die präzise Bestimmung der Orientierung haben.

Sofern das refraktive optische Element lediglich den zweiten Teilbereich abdeckt, kann auf vorteilhafte Weise innerhalb ein und desselben Kamerabildes sowohl ein Teilbild des unverschobenen ersten Teilbereichs als auch ein Teilbild des durch das refraktive optische Element verschobenen zweiten Teilbereichs ausgewertet werden. Damit lässt sich auf einfache Weise durch eine Differenzbetrachtung zwischen (a) einer realen relativen räumlichen Lage zwischen zumindest einer ersten Markierung des ersten Teilbereichs und einer zweiten Markierung des zweiten Teilbereichs und (b) einer virtuellen relativen räumlichen Lage zwischen der ersten Markierung und der zweiten Markierung der refraktive Einfluss des optischen Elements besonders genau ermitteln. Die Verschiebung kann somit auf einfache Weise durch eine entsprechende Musterverschiebung bzw. einen entsprechenden Positionsvergleich der Referenzstruktur im ersten Teilbereich mit der Referenzstruktur im zweiten Teilbereich bestimmt werden.

Unter dem Begriff optische Dicke ist das Produkt aus der tatsächlichen Dicke des refraktiven optischen Elements und dem jeweiligen Brechungsindex zu verstehen. Im Falle einer exakt senkrechten Orientierung der Kamera zu der Referenzebene entspricht die optische Dicke der optischen Weglänge, die sich im allgemeinen Fall aus dem Linienintegral des Brechungsindexes über den im refraktiven optischen Element zurückgelegten Lichtweg ergibt.

Bei Verwendung eines stufenartig bzw. treppenartig geformten und entsprechend positionierten refraktiven optischen Elements ist die Verschiebung der Referenzstruktur im ersten Teilbereich unterschiedlich zu der Verschiebung der Referenzstruktur im zweiten Teilbereich. Aus der Differenz der beiden Verschiebungen lässt sich ebenso auf einfache Weise die exakte Orientierung der Kamera relativ zu der Referenzebene bestimmen.

Bevorzugt ist das refraktive optische Element aus einem homogenen optisch transparenten Material hergestellt, so dass das Verhältnis der beiden optischen Dicken durch das Verhältnis der tatsächlichen Dicken der beiden Abschnitte wiedergegeben ist. Es ist jedoch auch denkbar, dass das refraktive optische Element aus unterschiedlichen Materialien hergestellt ist, welche unterschiedliche Brechungsindizes aufweisen. In diesem Fall kann das refraktive optische Element auch die Form einer planparallelen optisch transparenten Platte aufweisen.

Gemäß Anspruch 4 befindet sich, sofern das refraktive optische Element die gestufte Form aufweist, die Referenzstruktur an dem refraktiven optischen Element insbesondere an einer planen Unterseite des refraktiven optischen Elements. Dies hat den Vorteil, dass das refraktive optische Element auf einfache Weise in Form von stufenartigen Glasbausteinen gefertigt werden können, wobei eine hochgenaue Markierung bzw. Struktur lediglich an der planen Unterseite angebracht werden muss. Dies erleichtert die Fertigung derartiger Präzisionsbauelemente erheblich.

Gemäß Anspruch 5 befindet sich die Referenzstruktur auf einem Referenzelement. Insbesondere befindet sich die Referenzstruktur auf einer Referenzplatte. Dabei kann als Referenzelement eine Glasplatte verwendet werden, welche aus einem Glasmaterial hergestellt ist, das einen besonders niedrigen thermischen Ausdehnungskoeffizienten aufweist. Selbstverständlich gilt dies auch für das refraktive optische Element. Damit ist auch bei unterschiedlichen oder sogar schwankenden Umgebungstemperaturen eine zuverlässige Bestimmung der Kameraorientierung möglich.

Die Referenzstruktur kann auf der Glasplatte mit hoher räumlicher Genauigkeit aufgebracht werden, wobei die Positionen einzelner Marken genau bekannt sind. Das Aufbringen der Referenzstruktur kann durch photolithographische Verfahren erfolgen, die beispielsweise bei der Strukturierung von Leiterplatten verwendet werden.

Es wird darauf hingewiesen, dass das beschriebene Verfahren sowohl mittels einer Auflichtmessung als auch mittels einer Durchlichtmessung durchgeführt werden kann. Im Falle einer Auflichtmessung befindet sich in Bezug auf das Referenzelement die Kamera und eine entsprechende Beleuchtungseinheit auf der gleichen Seite Selbstverständlich befindet sich während der Messung das refraktive optische Element zwischen der Referenzstruktur und der Kamera. Im Falle einer Durchlichtmessung befindet sich die Kamera auf einer Seite des Referenzelements und die Beleuchtung befindet sich auf der gegenüberliegenden Seite des Referenzelements.

Gemäß Anspruch 6 wird das refraktive optische Element unmittelbar auf das Referenzelement gelegt. Dies hat den Vorteil, dass bei einer ebenen Referenzebene die Höhenlage des optischen Elements relativ zu der Referenzstruktur exakt festgelegt ist. Damit kann der Einfluss des refraktiven optischen Elements auf die Verschiebung der realen Referenzstruktur hin zu einer optisch virtuellen Referenzstruktur genau vorhergesagt werden, so dass eine besonders genaue Bestimmung der effektiven Orientierung der Kamera möglich ist, ohne dass für das refraktive optische Element eine komplizierte Handhabung erforderlich wäre.

Gemäß Anspruch 7 wird die Verschiebung der Referenzstruktur von der Kamera mittels einer telezentrischen Abbildung erfasst. Dies hat den Vorteil, dass die optische Abbildung einen von der Objektentfernung konstanten Abbildungsmaßstab aufweist, so dass auch Strukturen in unterschiedlicher Höhenlage scharf auf einen optischen Sensor, beispielsweise einen CCD-Chip, abgebildet werden. Die telezentrische Abbildung kann auf einfache Weise mittels einer Telezentrieblende realisiert werden, welche koaxial zu der optischen Achse in dem Strahlengang zwischen einer Kameraoptik und einem lichtsensitiven Element der Kamera angeordnet ist.

Es wird darauf hingewiesen, dass bei einem exakt telezentrischen Strahlengang die Referenzstruktur mit exakt parallelen Lichtstrahlen erfasst werden müsste. In diesem Fall wäre jedoch keine optische Abbildung möglich, da aus Sicht der Kamera die Bildebene im Unendlichen liegen würde. Aus diesem Grund kann die durch eine Telezentrieblende erfolgte optische Abbildung als "quasi telezentrische Abbildung" bezeichnet werden, bei der lediglich Lichtstrahlen zu der optischen Abbildung beitragen, welche die in der optischen Achse der Kamera angeordnete Telezentrieblende passieren und welche somit in einem Winkel von zumindest nahezu 90° auf die Referenzebene treffen.

Gemäß Anspruch 8 ist die Referenzebene die Bestückebene eines Bestückautomaten. Dies hat den Vorteil, dass das beschriebene Verfahren auf besonders vorteilhafte Weise in herkömmlichen Bestückautomaten angewendet werden kann.

Bestückautomaten weisen typischerweise einen Bestückkopf auf, mit dem elektronische Bauelemente von einer Bauelementzuführeinrichtung abgeholt, zu einer Bestückposition oberhalb eines Bauelementeträgers transportiert und an vorgegebenen Stellen auf den Bauelementeträger aufgesetzt werden. Dabei wird der Bauelementeträger derart positioniert, dass die flächige Oberseite des Bauelementeträgers mit der Referenzebene zusammenfällt, auf welcher Oberseite sich die Bauelement-Anschlussflächen für eine elektrische Kontaktierung der Bauelemente befinden. Derartige Bestückautomaten werden als Pick & Place Bestückautomaten bezeichnet.

Es wird ausdrücklich darauf hingewiesen, dass das beschriebene Verfahren zur Bestimmung der Orientierung einer Kamera relativ zu einer Referenzebene auch bei anderen Arten von Bestückautomaten, beispielsweise bei so genannten Chip-Shootern eingesetzt werden kann.

Mit dem unabhängigen Patentanspruch 9 wird eine Bestückvorrichtung zum automatischen Bestücken von Leiterplatten mit Bauelementen geschaffen. Die geschaffene Bestückvorrichtung weist auf (a) eine Kamera, (b) eine Referenzebene, welche relativ zu der Kamera derart angeordnet ist, dass zwischen der Kamera und der Referenzebene ein refraktives optisches Element einbringbar ist, wobei das refraktive optische Element (b1) eine planparallele optisch transparente Platte ist oder (b2) eine gestufte Form aufweist, die zumindest einen ersten Abschnitt mit einer ersten optischen Dicke und einen zweiten Abschnitt mit einer im Vergleich zu der ersten optischen Dicke unterschiedlichen zweiten optischen Dicke aufweist. Die geschaffene Bestückvorrichtung weist ferner eine Datenverarbeitungseinrichtung auf, welche zur Durchführung des oben genannten Verfahrens zum Bestimmen der Orientierung einer Kamera relativ zu einer Referenzebene eingerichtet ist.

Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellungen
- Figur 1: eine perspektivische Darstellung einer Bestückvorrichtung zur Durchführung des Verfahrens zum Bestimmen der Orientierung einer Kamera relativ zu einer Referenzebene,
- Figur 2a: eine Referenzplatte mit einer Referenzstruktur, welche eine Mehrzahl von kreisförmigen Referenzmarken aufweist,
- Figur 2b: die in Figur 2a dargestellte Referenzplatte, bei der ein Teil der Referenzstruktur mit einer Glasplatte bedeckt ist,
- Figur 2c: eine Querschnittsansicht der in Figur 2b dargestellten teilweise bedeckten Referenzplatte und einer Kamera, die gegenüber der Normalen der Referenzplatte um einen Winkel α verkippt ist,
- Figur 3a: die optische Abbildung zwischen einer in einer Referenzebene befindlichen Referenzmarke und einer in einem Winkel von 90° zur Referenzebene orientierten Kamera und
- Figur 3b: die durch eine Glasplatte verursachte optische Verschiebung der in Figur 3a dargestellten Referenzmarke hin zu einer virtuellen Referenzmarke.

An dieser Stelle bleibt anzumerken, dass sich in der Zeichnung die Bezugszeichen von gleichen oder von einander entsprechenden Komponenten lediglich in ihrer ersten Ziffer unterscheiden.

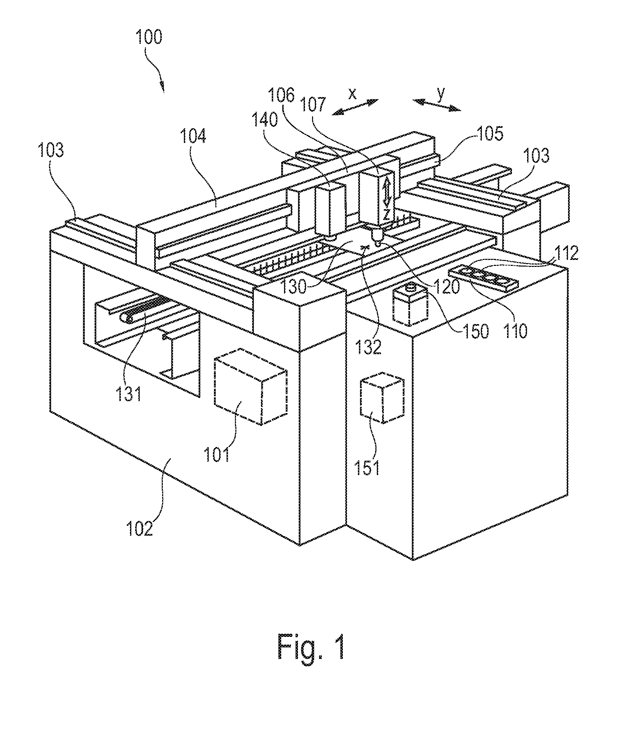

Figur 1 zeigt einen Bestückautomaten 100, welcher einen Rahmen 102 aufweist, an dem zwei parallel ausgerichtete Führungen 103 angebracht sind. Die beiden Führungen 103 tragen einen quer stehenden Trägerarm 104. Der quer stehende Trägerarm 104 weist selbst eine Führung 105 auf, an welchem ein Trägerelement 106 verschiebbar gelagert ist. Die beiden Führungen 103 verlaufen entlang einer y-Richtung, die Führung 105 verläuft entlang einer x-Richtung. An dem Trägerelement 106 ist ein Bestückkopf 107 angeordnet, welcher zumindest eine Haltevorrichtung 120 aufweist. Die Haltevorrichtung ist eine Saugpipette 120, die mittels eines nicht dargestellten Antriebs entlang einer zu der x- und zu der y-Richtung senkrechten z-Richtung verschiebbar ist.

Um die Winkellage von aufgenommenen Bauelementen zu korrigieren und um damit die Bauelemente in einer korrekt Orientierung bestücken zu können, ist ferner ein nicht dargestellter Drehantrieb vorgesehen. Mittels des Drehantriebs kann die Saugpipette 120 um ihre Längsachse gedreht werden.

Der Bestückautomat 100 weist ferner eine Bauelement-Zuführeinrichtung 112 auf, über welche in Figur 1 nicht dargestellte Bauelemente dem Bestückprozess zugeführt werden können. Ferner umfasst der Bestückautomat 100 ein Förderband 131, mit dem ein Bauelementeträger bzw. eine Leiterplatte 130 in den Bestückbereich eingebracht werden kann. Die Saugpipette 107 kann durch eine entsprechende Bewegung des Bestückkopfes 107 parallel zu der x-y-Ebene innerhalb des gesamten Bestückbereichs positioniert werden.

Der Bestückautomat 100 weist außerdem einen Prozessor bzw. eine Datenverarbeitungseinrichtung 101 auf. Auf der Datenverarbeitungseinrichtung 101 kann ein Bearbeitungsprogramm für den Bestückautomaten 100 zum Bestücken von Leiterplatten mit Bauelementen ausgeführt werden, so dass alle Komponenten des Bestückautomaten 100 in synchronisierter Weise arbeiten und somit zu einem fehlerfreien und zügigem Bestücken von Leiterplatten mit Bauelementen beitragen.

An dem Trägerelement 106 ist zusätzlich eine sog. Leiterplatten-Kamera 140 befestigt, welche zur Erfassung einer an der Leiterplatte 130 angebrachten Markierung 132 vorgesehen ist. Auf diese Weise kann die genaue Position der in dem Bestückbereich eingebrachten Leiterplatte 130 durch eine Lagevermessung der Markierung 132 innerhalb des Gesichtsfeldes der Leiterplatten-Kamera 140 bestimmt werden.

Zur Positionsvermessung und zur Kontrolle von aufgenommenen Bauelementen ist eine Kamera 150 vorgesehen, welche gemäß dem hier dargestellten Ausführungsbeispiel in einer festen Position an dem Bestückautomaten 100 angeordnet ist. Die optische Bauelement-Vermessung erfolgt bevorzugt unmittelbar nach der Aufnahme des Bauelements von der Bauelement-Zuführeinrichtung 110 durch eine entsprechende Positionierung des Bestückkopfes 107 oberhalb der Bauelemente-Kamera 150. Das von der Kamera 150 aufgenommene Bild wird in einer Auswerteeinheit 151 ausgewertet und dabei die Lage des aufgenommenen Bauelements relativ zu der Saugpipette 120 ermittelt.

Die Auswerteeinheit 151 kann auch in der Datenverarbeitungseinrichtung 101 integriert sein. Dabei kann die Auswerteeinheit 151 mittels einer eigenen Hardware oder auch mittels einer geeigneten Software realisiert sein.

Es wird darauf hingewiesen, dass die Erfindung keineswegs auf die Verwendung in dem hier dargestellten Bestückautomaten 100 beschränkt ist. Die Erfindung kann beispielsweise auch mit einer Bauelemente-Kamera realisiert werden, welche zusammen mit dem Bestückkopf verfahren wird und welche dafür vorgesehen ist, die aufgenommenen Bauelemente während des Transports von der Aufnahmeposition hin zu der Bestückposition zu vermessen.

Ebenso kann die Erfindung im Zusammenhang mit einem sog. Mehrfach-Bestückkopf eingesetzt werden, welcher mehrere Haltevorrichtungen aufweist und welcher somit gleichzeitig mehrere Bauelemente transportieren kann. Dabei können die Haltevorrichtungen zeilen- bzw. matrixartig angeordnet sein. Ebenso können die Haltevorrichtungen jedoch auch um eine Rotationsachse radial abstehend abgeordnet sein, so dass durch eine Drehung der Haltevorrichtungen mehrere Bauelemente sequentiell aufgenommen und auch wieder abgesetzt werden können. Selbstverständlich kann die Erfindung auch mit beliebigen anderen Arten von Einfach- oder Mehrfach-Bestückköpfen realisiert werden.

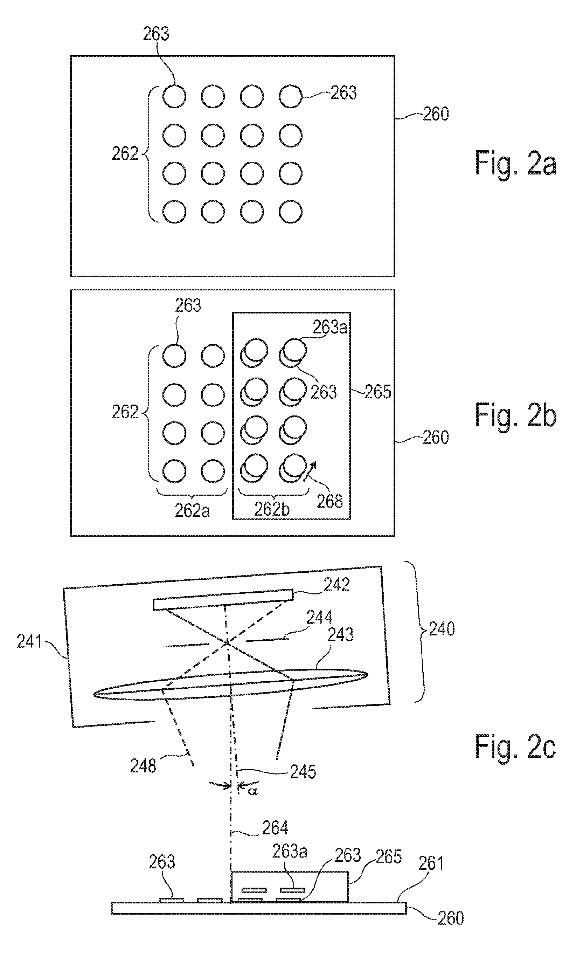

Figur 2a zeigt eine Referenzplatte 260 mit einer Referenzstruktur 262, welche eine Mehrzahl von kreisförmigen Referenzmarken 263 aufweist. Selbstverständlich können auch beliebige andere Formen und Strukturen verwendet werden. Die Referenzplatte 260 ist gemäß dem hier dargestellten Ausführungsbeispiel aus einem Glasmaterial hergestellt, welches einen niedrigen thermischen Ausdehnungskoeffizienten aufweist. Damit ist die räumliche Anordnung der auf der Referenzplatte 260 ausgebildeten Referenzmarken 263 auch bei schwankenden Umgebungstemperaturen weitgehend konstant. Ferner sind die Referenzmarken 263 mit einer hohen räumlicher Genauigkeit aufgebracht, wobei die Positionen sämtlicher Marken 263 genau bekannt sind.

Figur 2b zeigt die Referenzplatte 260, bei der ein refraktives optisches Element 265 auf einen zweiten Teilbereich 262b der Referenzstruktur 262 gelegt ist. Ein erster Teilbereich 262a der Referenzstruktur 262 ist nicht von dem refraktiven Element 265 bedeckt. Gemäß dem hier dargestellten Ausführungsbeispiel ist das refraktive optische Element eine planparallel Glasplatte 265. Dies hat den Vorteil, dass die Geometrie des refraktiven optischen Elements 265 genau bekannt ist und somit die Brechung der Lichtstrahlen genau berechnet werden kann, mit welchen Lichtstrahlen die unter der Glasplatte 265 befindlichen Referenzmarken 263 von einer Kamera erfasst werden.

Figur 2c zeigt eine Querschnittsansicht der teilweise bedeckten Referenzplatte 260 und einer Kamera 240, die gegenüber der Normalen der Referenzplatte 260 um einen Winkel α verkippt ist. Die Kamera 240, welche gemäß dem hier dargestellten Ausführungsbeispiel eine Leiterplatten-Kamera eines Bestückautomaten ist, weist ein Gehäuse 241 auf, in dem ein optischer Sensor 242, insbesondere ein CCD-Sensor 242, sowie eine Abbildungsoptik 243 und eine so genannte Telezentrieblende 244 angeordnet ist.

Die Telezentrieblende 244 ist koaxial zu der optischen Achse in dem Strahlengang zwischen einer Abbildungsoptik 243 und dem lichtsensitiven Element 242 angeordnet. Die Telezentrieblende 244 sorgt dafür, dass zu der optischen Abbildung innerhalb eines quasi telezentrischen Strahlengangs 248 nicht nur lediglich diejenigen Lichtstrahlen beitragen, die exakt parallel zu der optischen Achse 245 der Kamera 240 verlaufen. In diesem Fall wäre nämlich gar keine optische Abbildung möglich, da aus Sicht der Kamera 240 die Bildpunkte im Unendlichen liegen würden. Die Telezentrieblende 244 weist demzufolge eine derart große Blendenöffnung auf, dass zur optischen Abbildung auch Lichtstrahlen beitragen, die innerhalb eines relativ engen Winkelbereichs nahezu parallel zu der optischen Achse 245 verlaufen.

Die Oberseite 261 der Referenzplatte 260, an der die Referenzstruktur 262 ausgebildet ist, stellt gemäß dem hier beschriebenen Ausführungsbeispiel die Referenzebene 261 dar. Wie aus Figur 2c ersichtlich, ist die optische Achse 245 der Kamera 240 relativ zu der Flächennormalen 264 der Referenzebene 261 um einen Winkel α verkippt. Dies führt bei der optischen Abbildung der von der Glasplatte 265 bedeckten Referenzmarken 263 infolge des so genannten Parallaxe-Effekts und infolge einer Refraktion des Messlichts 248 beim Eintritt in die Glasplatte 265 zu einer optischen Verschiebung der betreffenden Referenzmarken 263 hin zu virtuellen Bildern 263a der Referenzmarken 263. Diese optische Verschiebung ist in Figur 2b mit dem Bezugszeichen 268 versehen. Dabei bewirkt die Verkippung der Kamera aufgrund des Parallaxe-Effekts eine seitliche Verschiebung und die Refraktion des Messlichts 248 beim Eintritt in die Glasplatte 265 eine vertikale Verschiebung, wobei sich die seitliche und die vertikale Verschiebung entsprechend überlagern.

Anders ausgedrückt bedeutet dies: Aufgrund der Refraktion durch das optische Element 265 verschiebt sich die Position der betreffenden Referenzmarken 263 nach oben hin zur Kamera 240. Da jedoch die Kamera 240 um einen Winkel α gegenüber der Normalen 264 verkippt ist, ergibt sich zusätzlich zu der Verschiebung nach oben noch eine seitliche Verschiebung nach rechts. Die Größe dieser seitlichen Verschiebung hängt direkt von dem Verkippungswinkel α ab. Durch eine entsprechende Bildauswertung, bei der die Positionen der unverschobenen Referenzmarken 263 mit den Positionen der verschobenen virtuellen Referenzmarken 263a verglichen werden, kann somit der Verkippungswinkel α genau bestimmt werden. Selbstverständlich ist dafür eine genaue Kenntnis (a) der Dicke der planparallelen Glasplatte 265 und (b) des Brechungsindexes der Glasplatte 265 erforderlich.

An dieser Stelle wird darauf hingewiesen, dass die Referenzstruktur 262 eine beliebige Anzahl von Referenzmarken 263 aufweisen kann, die eine Vielzahl von verschiedenen Formen habe können. So sind beispielsweise bei einer gleichzeitigen Vermessung von unverschobenen und aufgrund des Parallaxe-Effekts verschobenen Referenzmarken zumindest zwei Referenzmarken erforderlich. Es kann jedoch selbstverständlich auch lediglich eine Referenzmarkierung verwendet werden, welche so groß ist, dass sie sich über beide Teilbereiche 262a und 262b erstreckt. Dies bedeutet, dass ein Teil der Referenzmarkierung neben der Glasplatte 265 liegt und ein anderer Teil der Referenzmarkierung von der Glasplatte 265 bedeckt ist.

Im Falle einer sequentiellen Vermessung der unverschobenen Referenzstruktur und der verschobenen Referenzstruktur ist es prinzipiell ausreichend, dass die Referenzstruktur lediglich eine Referenzmarke aufweist. In diesem Fall wird zunächst ein Kamerabild der frei liegenden Referenzmarke aufgenommen und dieses Bild bzw. die genaue Position der erfassten unverschobenen Referenzmarke abgespeichert. Nachfolgend wird die Glasplatte auf die Referenzmarke gelegt und die Position der infolge des Parallaxe-Effekts verschobenen Referenzmarke bestimmt. Die Messgenauigkeit kann jedoch auch bei der sequentiellen Vermessung dadurch erhöht werden, dass nicht nur die optische Verschiebung einer einzigen Referenzmarke, sondern die optischen Verschiebungen von zumindest mehreren Referenzmarken vermessen und zur Bestimmung der Orientierung der Kamera herangezogen werden.

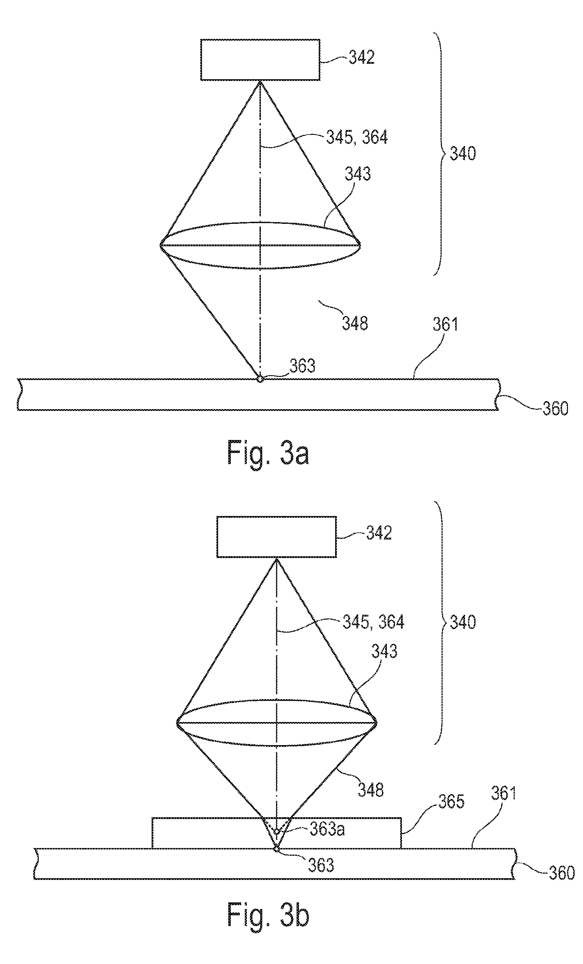

Aus Gründen der Übersichtlichkeit ist in Figur 2c nicht der vollständige Strahlengang eingezeichnet. Der Parallaxe-Effekt bei einem Verkippungswinkel von α = 0, d.h. bei einer exakt parallelen Orientierung der optischen Achse 245 relativ zu der Normalen 264, wird jedoch nachfolgend anhand von Figur 3a und 3b erläutert.

Figur 3a zeigt die optische Abbildung zwischen einer in einer Referenzebene 361 befindlichen Referenzmarke 363 und einer in einem Winkel von 90° zur Referenzebene orientierten Kamera 340. Die optische Achse 345 der Kamera 340 fällt mit der Flächennormalen 364 der Referenzebene 361 zusammen.

Der Parallaxe-Effekt tritt selbstverständlich auch bei einem nicht telezentrischen Strahlengang bzw. einem nicht quasi telezentrischen Strahlengang auf. Damit ist die Bestimmung der Orientierung der Kamera 340 auch ohne den Einsatz einer Telezentrieblende möglich, welche, wie aus Figur 2c ersichtlich, zwischen einer Abbildungsoptik 343 und dem optischen Sensor 342 angeordnet sein könnte.

Eine optische Abbildung einer Referenzmarke 363, welche innerhalb einer Referenzebene 361 auf einer Referenzplatte 360 angeordnet ist, erfolgt in bekannter Weise durch einen mit dem Bezugszeichen 348 gekennzeichneten Strahlengang. Die Referenzmarke 363 wird mittels der Abbildungsoptik 343 auf den optischen Sensor 342 abgebildet.

Figur 3b zeigt die durch eine Glasplatte 365 bewirkte optische Verschiebung der Referenzmarke 363 hin zu einer virtuellen Referenzmarke 363a. Infolge der Lichtbrechung an der Grenzfläche zum optisch dichteren Medium der Glasplatte 365 verschiebt sich die Position der Referenzmarke 363 hin zu einem virtuellen Bild 363a der Referenzmarke 363.

Im Falle einer in Figur 3b nicht dargestellten Verkippung der Kamera 340 relativ zu der Referenzebene 361 würde, wie bereits oben anhand von Figur 2c erläutert, das virtuelle Bild der Referenzmarke zusätzlich zur Seite hin verschieben werden. Aus der Richtung und aus der Stärke der Verschiebung kann der Verkippungswinkel der Kamera exakt bestimmt werden.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

### Bezugszeichenliste

- 100: Bestückautomat
- 101: Datenverarbeitungseinrichtung / Prozessor
- 102: Rahmen
- 103: Führungen
- 104: quer stehender Trägerarm
- 105: Führung
- 106: Trägerelement
- 107: Bestückkopf
- 110: Bauelement-Zuführeinrichtung
- 112: Abholposition
- 120: Haltevorrichtung / Sauggreifer / Saugpipette
- 130: Bauelementeträger / Leiterplatte / Referenzebene
- 131: Förderband
- 132: Markierung
- 140: Leiterplatten-Kamera
- 150: Bauelemente-Kamera
- 151: Auswerteeinheit

- 240: Leiterplatten-Kamera
- 241: Gehäuse / Chassis
- 242: optischer Sensor
- 243: Abbildungsoptik
- 244: Blende / Telezentrieblende
- 245: optische Achse
- 248: Strahlengang
- 260: Referenzelement / Referenzplatte
- 261: Oberseite der Referenzplatte / Referenzebene
- 262: Referenzstruktur
- 262a: erster Teilbereich
- 262b: zweiter Teilbereich
- 263: Referenzmarke
- 263a: virtuelles Bild der Referenzmarke 263
- 264: Normale der Referenzebene 261
- 265: refraktives optisches Element / Glasplatte
- 268: optischen Verschiebung

- α: Verkippungswinkel

- 340: Leiterplatten-Kamera
- 342: optischer Sensor
- 343: Abbildungsoptik
- 345: optische Achse
- 348: Strahlengang
- 360: Referenzelement / Referenzplatte
- 361: Referenzebene
- 363: Referenzmarke
- 363a: virtuelles Bild der Referenzmarke 363
- 364: Flächennormale der Referenzebene 361
- 365: refraktives optisches Element / Glasplatte

## Patentansprüche

1. Verfahren zum Bestimmen der Orientierung einer Kamera (240) relativ zu einer Referenzebene (261), insbesondere einer Kamera zur Vermessung von Kalibrierungsbauelementen in einem Bestückautomaten, welches Verfahren folgende Schritte aufweist:
• Erfassen einer optischen Verschiebung (268) einer in der Referenzebene (261) befindlichen Referenzstruktur (262), wobei die optische Verschiebung (268) durch ein refraktives optisches Element (265) verursacht wird, welches zwischen der Kamera (240) und der Referenzstruktur (262) angeordnet ist, und
• Ermitteln der Orientierung der Kamera (240) relativ zu der Referenzebene (261) basierend auf der erfassten optischen Verschiebung (268) mittels einer der Kamera (140, 240) nachgeschalteten Auswerteeinheit (151),
wobei das Erfassen der optischen Verschiebung (268) der Referenzstruktur (262) folgende Schritte aufweist:
• Aufnehmen eines ersten Kamerabildes von zumindest einem Teil der Referenzstruktur (262),
• Einbringen des refraktiven optischen Elements (265) zwischen der Referenzstruktur (262) und der Kamera (240), und
• Aufnehmen eines zweiten Kamerabildes von zumindest dem Teil der Referenzstruktur (262).

2. Verfahren nach Anspruch 1, bei dem
das refraktive optische Element eine planparallele optisch transparente Platte (265) ist.

3. Verfahren zum Bestimmen der Orientierung einer Kamera (240) relativ zu einer Referenzebene (261), insbesondere einer Kamera zur Vermessung von Bauelementen in einem Bestückautomaten, welches Verfahren folgende Schritte aufweist:
• Erfassen einer optischen Verschiebung (268) einer in der Referenzebene (261) befindlichen Referenzstruktur (262), wobei die optische Verschiebung (268) durch ein refraktives optisches Element (265) verursacht wird, welches zwischen der Kamera (240) und der Referenzstruktur (262) angeordnet ist, und
• Ermitteln der Orientierung der Kamera (240) relativ zu der Referenzebene (261) basierend auf der erfassten optischen Verschiebung (268) mittels einer der Kamera (140, 240) nachgeschalteten Auswerteeinheit (151),
wobei das Erfassen der optischen Verschiebung (268) der Referenzstruktur (262) eine Auswertung eines Kamerabildes umfasst, welches Kamerabild sowohl einen ersten Teilbereich (262a) der Referenzstruktur (262) als auch einen zweiten Teilbereich (262b) der Referenzstruktur (262) zeigt, und wobei das refraktive optische Element (265)
- lediglich den zweiten Teilbereich (262b) abdeckt, oder
- eine gestufte Form aufweist, die zumindest einen ersten Abschnitt mit einer ersten optischen Dicke und einen zweiten Abschnitt mit einer im Vergleich zu der ersten optischen Dicke unterschiedlichen zweiten optischen Dicke aufweist, wobei
das refraktive optische Element derart positioniert wird, dass
der erste Abschnitt den ersten Teilbereich bedeckt und der zweite Abschnitt den zweiten Teilbereich bedeckt.

4. Verfahren nach Anspruch 3, bei dem, sofern das refraktive optische Element (265) die gestufte Form aufweist,
sich die Referenzstruktur an dem refraktiven optischen Element insbesondere an einer planen Unterseite des refraktiven optischen Elements befindet.

5. Verfahren nach einem der Ansprüche 1 bis 4, bei dem
sich die Referenzstruktur (262) auf einem Referenzelement (260), insbesondere auf einer Referenzplatte (260), befindet.

6. Verfahren nach Anspruch 5, bei dem
das refraktive optische Element (265) unmittelbar auf das Referenzelement (260) gelegt wird.

7. Verfahren nach einem der Ansprüche 1 bis 6, bei dem
die Verschiebung (268) der Referenzstruktur (262) von der Kamera (240) mittels einer telezentrischen Abbildung erfasst wird.

8. Verfahren nach einem der Ansprüche 1 bis 7, bei dem
die Referenzebene (261) zumindest annähernd die Bestückebene eines Bestückautomaten (100) ist.

9. Bestückautomat zum Bestücken von Leiterplatten (130) mit Bauelementen, aufweisend
eine Kamera (240),
eine Referenzebene (261), welche relativ zu der Kamera (240) derart angeordnet ist, dass zwischen der Kamera (240) und der Referenzebene (261) ein refraktives optisches Element (265) einbringbar ist, wobei das refraktive optische Element (265)
- eine planparallele optisch transparente Platte ist oder
- eine gestufte Form aufweist, die zumindest einen ersten Abschnitt mit einer ersten optischen Dicke und einen zweiten Abschnitt mit einer im Vergleich zu der ersten optischen Dicke unterschiedlichen zweiten optischen Dicke aufweist, und
eine Datenverarbeitungseinrichtung (101), welche zur Durchführung des Verfahrens nach einem der Ansprüche 1 bis 8 eingerichtet ist.

## Claims

1. Method for determining the orientation of a camera (240) relative to a reference plane (261), in particular a camera for a measurement of calibration components in a mounting machine, the method comprising the following steps:
• capturing an optical displacement (268) of a reference structure (262) situated in the reference plane (261), wherein the optical displacement (268) is caused by a refractive optical element (265) arranged between the camera (240) and the reference structure (262), and
• ascertaining the orientation of the camera (240) relative to the reference plane (261) based on the captured optical displacement (268) by an evaluation unit (151) being connected downstream of the camera (140, 240),
wherein the capturing of the optical displacement (268) of the reference structure (262) comprises the following steps:
• taking a first camera image of at least a part of the reference structure (262),
• inserting of the refractive optical element (265) between the reference structure (262) and the camera (240), and
• taking a second camera image of at least the part of the reference structure (262).

2. Method according to claim 1, wherein
the refractive optical element is a plane-parallel optically transparent plate (265).

3. Method for determining the orientation of a camera (240) relative to a reference plane (261), in particular a camera for a measurement of components in a mounting machine, the method comprising the following steps:
• capturing an optical displacement (268) of a reference structure (262) situated in the reference plane (261),
wherein the optical displacement (268) is caused by a refractive optical element (265) arranged between the camera (240) and the reference structure (262), and
• ascertaining the orientation of the camera (240) relative to the reference plane (261) based on the captured optical displacement (268) by an evaluation unit (151) being connected downstream of the camera (140, 240),
wherein the capturing of the optical displacement (268) of the reference structure (262) includes an elevation of a camera image showing both a first portion (262a) of the reference structure (262) and a second portion (262b) of the reference structure (262), and
wherein the refractive optical element (265)
• merely covers the second portion (262b), or
• comprises a stepped form comprising at least a first section with a first optical thickness and a second section with a second optical thickness being different compared to the first optical thickness, wherein
the refractive optical element is positioned in such a way that
the first section covers the first portion and the second section covers the second portion.

4. Method according to claim 3, wherein in case the refractive optical element (265) comprises the stepped form,
the reference structure is situated at the refractive optical element, in particular at a plane bottom side of the refractive optical element.

5. Method according to one of the claims 1 to 4, wherein
the reference structure (262) is situated on a reference element (260), in particular on a reference plate (260).

6. Method according to claim 5, wherein
the refractive optical element (265) is directly laid on the reference element (260).

7. Method according to one of the claims 1 to 6, wherein
the displacement (268) of the reference structure (262) of the camera (240) is captured by a telecentric mapping.

8. Method according to one of the claims 1 to 7, wherein
the reference plane (261) is at least approximately the mounting plane of a mounting machine (100).

9. Mounting machine for mounting components to printed circuit boards (130), comprising
a camera (240),
a reference plane (261), which is arranged relative to the camera (240), in such way that a refractive optical element (265) is insertable between the camera (240) and the reference plane (261), wherein the refractive optical element (265)
• is a plane-parallel optically transparent plate or
• comprises a stepped form comprising at least a first section with a first optical thickness and a second section with a second optical thickness being different compared with the first optical thickness, and
a data processing device (101), which is configured for performing the method according to one of the claims 1 to 8.

## Revendications

1. Procédé de détermination de l'orientation d'une caméra (240) par rapport à une surface de référence (261), en particulier d'une caméra pour le mesurage d'éléments de calibration dans un automate d'équipement, lequel procédé comprend les étapes suivantes :
- détection d'un décalage optique (268) d'une structure de référence (262) se trouvant dans la surface de référence (261), le décalage optique (268) étant causé par un élément optique réfractif (265) qui est disposé entre la caméra (240) et la structure de référence (262), et
- détermination de l'orientation de la caméra (240) par rapport à la surface de référence (261) sur la base du décalage optique (268) détecté et au moyen d'une unité d'évaluation (151) placée en aval de la caméra (140, 240),
la détection du décalage optique (268) de la structure de référence (262) comprenant les étapes suivantes :
- enregistrement d'une première image de caméra d'au moins une partie de la structure de référence (262),
- introduction de l'élément optique réfractif (265) entre la structure de référence (262) et la caméra (240), et
- enregistrement d'une seconde image de caméra d'au moins la partie de la structure de référence (262).

2. Procédé selon la revendication 1, dans lequel
l'élément optique réfractif est une plaque optiquement transparente à faces planes et parallèles (265).

3. Procédé de détermination de l'orientation d'une caméra (240) par rapport à une surface de référence (261), en particulier d'une caméra servant au mesurage de composants dans un automate d'équipement, lequel procédé comprend les étapes suivantes :
- détection d'un décalage optique (268) d'une structure de référence (262) se trouvant dans la surface de référence (261),
le décalage optique (268) étant causé par un élément optique (265) qui est disposé entre la caméra (240) et la structure de référence (262), et
- détermination de l'orientation de la caméra (240) par rapport à la surface de référence (261) sur la base du décalage optique (268) détecté et au moyen d'une unité d'évaluation (151) placée en aval de la caméra (140, 240),
la détection du décalage optique (268) de la structure de référence (262) comprenant une évaluation d'une image de la caméra, laquelle image de la caméra montrant aussi bien une première zone partielle (262a) de la structure de référence (262) qu'une seconde zone partielle (262b) de la structure de référence (262), et
l'élément optique réfractif (265)
- recouvrant seulement la seconde zone partielle (262b), ou
- présentant une forme étagée qui comprend au moins un premier secteur ayant une première épaisseur optique et un second secteur ayant une seconde épaisseur optique différente par comparaison à la première épaisseur optique,
l'élément optique réfractif étant positionné de manière telle que le premier secteur recouvre la première zone partielle et le second secteur recouvre la seconde zone partielle.

4. Procédé selon la revendication 3, dans lequel, dans la mesure où l'élément optique réfractif (265) présente la forme étagée, la structure de référence se trouve au niveau de l'élément optique réfractif, en particulier au niveau d'une face inférieure plane de l'élément optique réfractif.

5. Procédé selon l'une quelconque des revendications 1 à 4, dans lequel la structure de référence (262) se trouve sur un élément de référence (260), en particulier sur une plaque de référence (260).

6. Procédé selon la revendication 5, dans lequel
l'élément optique réfractif (265) est posé directement sur l'élément de référence (260).

7. Procédé selon l'une quelconque des revendications 1 à 6, dans lequel le décalage (268) de la structure de référence (262) est détecté par la caméra (240) au moyen d'une reproduction télécentrique.

8. Procédé selon l'une quelconque des revendications 1 à 7, dans lequel la surface de référence (261) est au moins approximativement la surface d'équipement d'un automate d'équipement (100).

9. Automate d'équipement servant à l'équipement de cartes de circuit imprimé (130) avec des composants, comprenant
une caméra (240),
une surface de référence (261) qui est disposée par rapport à la caméra (240) de manière telle qu'un élément optique réfractif (265) puisse être introduit entre la caméra (240) et la surface de référence (261), l'élément optique réfractif (265)
- étant une plaque optiquement transparente à faces planes et parallèles ou
- présentant une forme étagée qui comprend au moins un premier secteur ayant une première épaisseur optique et un second secteur ayant une seconde épaisseur optique différente en comparaison à la première épaisseur optique, et
un dispositif de traitement de données (101) qui est agencé pour l'exécution du procédé selon l'une quelconque des revendications 1 à 8.
